# EUROPEAN PATENT APPLICATION

(11) **EP 1 560 333 A2**
(43) Date of publication of application: **03.08.2005**
(21) Application number: 05001394.5
(22) Date of filing: 25.01.2005
(51) Int. Cl.: H03K 5/135

(54) **A method and apparatus for generating variable delay**

(30) Priority: 02.02.2004 US 541403 P
(71) Applicant: Synthesys Research, Inc., Menlo Park, California 94025 (US)
(72) Inventor: Poskatcheev, Andrei, Corral de Tierra, CA 93908 (US)
(74) Representative: van Walstijn, Bartholomeus Gerard G.

(57) **Abstract**

Disclosed herein is a method and apparatus used to create variable delay output from a high-speed trigger input signal. A variable delay generation circuit includes a preconditioning circuit, operative to provide a preconditioned signal in response to an input signal. At least one delay tap path is coupled to the preconditioned signal, and is operative to provide a delayed version of the preconditioned signal. The delay path includes a delay element and a scaling circuit. A summing circuit is coupled to the at least one delay tap path and preconditioned signal, and is operative to provide an output signal exhibiting variable delay characteristics in response to the preconditioned signal and the delayed version of the preconditioned signal. The delayed version of the preconditioned signal may be provided by an elongated signal trace between the preconditioning circuit and the delay tap path. Through the combination of summing delayed and scaled versions of the input signal and the preconditioning of the input signal to have required rise/fall times and shapes, high-frequency variable delay is implemented that provides for fast, stable settings with consistent delay range and resolution.

## Description

### Field of the Invention:

This invention generally relates to test and measurement systems that need precise, high-speed variable delay of triggering edges.

### Description of the Related Art:

In recent years, the performance of high-speed communication facilities and devices have risen to a point that the ability to accurately achieve high-quality delay in a signal or trigger at very high frequencies can dramatically impact the type of test performed as well as the test time for such facilities and devices. Conventional mechanisms for achieving variable delay have had one or more drawbacks in areas of frequency capability, resolution of delay, linearity of delay, monotonicity of delay, speed of setting delay, reliability, temperature dependence of delay, and range of delay.

Past delay devices have included mechanical trombone-type variable delay structures, where a stepper motor is used to physically elongate a coaxial connection. Among other deficiencies, these devices suffer from slow setting speed, mechanical gear backlash and mechanical reliability. Another method for implementing variable delay is to create a phase-shifter using, for example, classic microwave methods for phase shifters. The aforementioned methods are not appropriate for general purpose use at they are frequency specific and typically do not conveniently cover the wide range of operating frequencies necessary for today's marketplace.

Another common variable delay implementation method is to create a transmission line structure of lumped inductor and capacitor elements, where the capacitor elements are variable capacitors (varactor diodes) that can be adjusted to tune the characteristic impedance and therefore the speed of the transmission line. These delay lines depend on the values of the inductors and variable capacitors (varactors) in the structure which can be temperature dependent. Additionally, commercially available discrete varactors limit the high-frequency usability of these devices.

A further method for implementing variable delay is to switch in fixed-element delays via a programmed method. This complementary method practically limits the resolution of the variable delay structure by the number of fixed-element delays that can reasonably be realized. This method is commonly used in conjunction with other methods as a coarse setting where the other method is the fine vernier. These fixed element delays are often implemented with fixed trace delays in printed wiring boards or substrates. Fixed element delays are also often implemented as a cascade of semiconductor gate delays. Semiconductor delays have great dependency on temperature as well as variation from part to part.

### SUMMARY OF THE INVENTION

Generically, variable delay functions are devices that provide a programmable amount of delay insertion into a data or trigger signal path. This translates, for example, to the rising/falling edge of an input signal being delayed at the output by varying amounts of delay as a function of the variable delay amount setting. The present invention provides for creating variable delay into a data or trigger signal path that operates with fine delay resolution at high frequencies and that covers a delay range which allows a corresponding device to be utilized as a delay vernier for a larger delay range structure.

A variable delay generation circuit includes a preconditioning circuit, operative to provide a preconditioned signal in response to an input signal. At least two delay tap paths are coupled to the preconditioned signal, and are operative to provide delayed versions of the preconditioned signal. Each delay path includes a delay element and a scaling circuit. A summing circuit is coupled to the at least two delay tap paths, and is operative to provide an output signal exhibiting variable delay characteristics in response to the preconditioned signal, the scaling circuits and the delayed versions of the preconditioned signal. The delayed version of the preconditioned signal may be provided by an elongated signal trace between the preconditioning circuit and the delay tap path.

An advantage provided by the present invention is that the variable delay function is accomplished in a manor that is quick to make setting changes and is compensated for temperature variations.

The present invention accepts a signal with triggering edges to be delayed at its input and then outputs a copy of this signal with the edges delayed as a function of an additional further input control. The delay mechanism is the result of summing two or more copies (taps) of the input signal where a known delay is inserted between the taps of the input signal as well as a finite bandwidth of edge transition and each tap's amplitude can be adjusted before the signals are summed. By adjusting the relative amplitudes of the different taps of the signal before they are summed, the resulting summed signal can reproduce the input signal at programmable delay shifts in the range defined by the fixed delay between the first input tap and the last input tap. Changing the amount of delay is simply provided by changing the gain/attenuation coefficients to the different taps to be summed. The maximum speed of operation is limited by what gain/attenuation process can be used as well as the summing process to be used.

### BRIEF DESCRIPTION OF THE DRAWINGS

For a further understanding of the objects and advantages provided by the present invention, reference should be had to the following detailed description, taken in conjunction with the accompanying drawing, in which like parts are given like reference numerals and wherein:
Fig. 1 is a schematic block diagram of an N-tap variable delay generation circuit of the present invention.
Fig. 2 is a graph of linear gain coefficients to apply to an exemplary two-tap embodiment of the present invention;
Fig. 3 is a timing diagram showing the output of the exemplary embodiment of the present invention to idealized inputs of triggering edges with zero rise/fall times;
Fig. 4 illustrates what coefficients would need to be applied to two sine wave signals that are 90 degrees out of phase such that constant output amplitude is still maintained;
Fig. 5 is a graph showing an example of sine/cosine gain coefficients to apply to the exemplary embodiment of the present invention;
Fig. 6 is a timing diagram showing the output of the exemplary embodiment of the present invention to sine wave input;
Fig. 7 is a timing diagram showing the output of the exemplary embodiment of the present invention to inputs of triggering edges with finite rise/fall times;
Fig. 8 is a schematic illustration of an exemplary two-tap embodiment of the present invention.

### DETAILED DESCRIPTION OF THE INVENTION

The present invention will now be described in greater detail with reference to the accompanying drawings, in which the preferred embodiments of the invention are shown. The present invention may, however, be embodied in many different forms and should not be construed as limited to the embodiment set forth herein; rather these embodiments are provided so that this disclosure will be thorough and complete and will fully convey the invention to those skilled in the art.

The present invention is a method and apparatus used to create variable delay for input trigger edges. The input is a signal containing trigger edges and the output is a like-signal containing nearly similar trigger edges that are delayed by a variable amount of delay. The variable nature of the output delay is controlled by a control input that varies the output delay from Tmin to Tmax where Tmax-Tmin = Δt is the delay range of the variable delay device. The control input in this invention controls the multiplying gain coefficients introduced to each tap before the taps are summed to create the delayed output signal. Multiplying gain coefficients can be implemented as voltage-variable amplifiers, as programmable attenuators or any suitable devices or methods that produce an output that is a voltage-scaled version of its input and where the scaling factor can be varied dynamically.

According to the present invention, the input signal is conditioned, for example, by using a low-pass filter which removes high-frequency components of the signal to ensure the input trigger edges have rise/fall times greater than 1/N of the Δt required, where N is the number of taps to be used. Smaller rise/fall times (approaching 1/N of Δt) will output less-smooth delayed trigger edges and require more complex calculations of gain coefficients. Longer rise/fall times (approaching 2/N of Δt) will create more simple calculation of gain coefficients. The response shape of the conditioned trigger edge (sine wave, gaussian, trapezoidal, etc) also has an impact on the calculations of gain coefficients, but in all cases, gain coefficients exist that will allow the disclosed circuit to output delayed trigger edges.

Copies (taps) of this conditioned signal are then delayed with respect to each other and then individual gain coefficients are applied to each tap. The resulting delayed and gained tap signals are then summed to provide the output. The present invention will be described in connection with a 2-tap structure is used; however, this is only for example and is not intended in any way to limit this invention to only a 2-tap structure. Larger, multi-tap (e.g. N-tap) structures are contemplated by and fall within the spirit and scope of the present invention and this disclosure. In larger structures, delays between taps can be the same or can be different as long as the rise/fall edge rates are sufficient to cover the longest delay increment in the structure. Longer structures implement larger delay range and are important for systems that require these longer ranges.

The calculation of the delay time used as the tap spacing and the rise/fall times that must result from the pre-conditioning of the input signals come from the required delay range and the number of taps to be used. The ideal delay range suitable for a 2-tap embodiment of this invention is approximately π/4 rad worth of delay for the highest-frequency input edges. Non-ideal conditions can also be used to use this same technique for higher frequency inputs and/or longer delay ranges. For example, for an input trigger signal with edges at 12.5 GHz rate, a 20 picosecond range of variable delay is readily attained by using an rise/fall time resulting from the pre-conditioning that are at least 10-20 picoseconds.

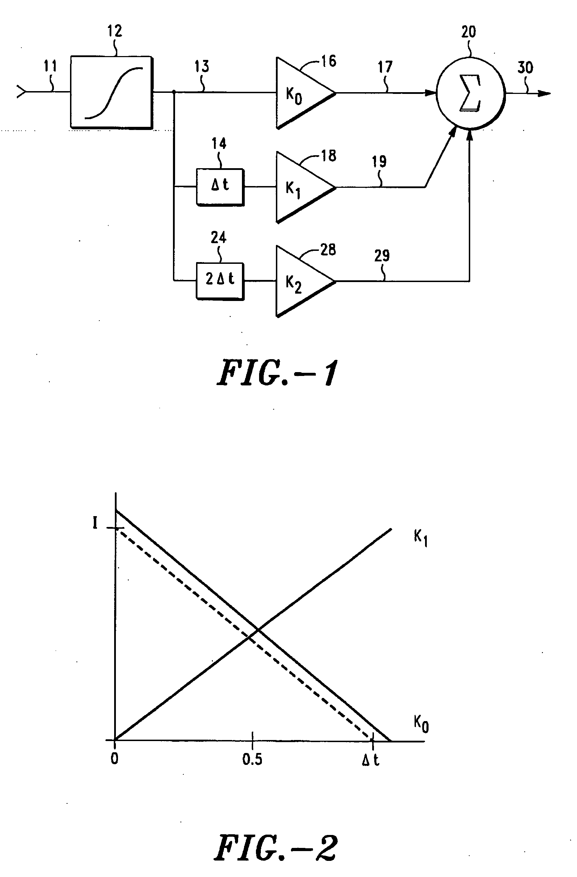

A better understanding of these principals and how they apply to the present invention can be had by understanding the accompanying drawings. Fig. 1 is a schematic block diagram of an N-tap variable delay generation circuit 10 configured to implement the variable delay functionality of the present invention on an input signal 11. In an exemplary embodiment, a two-tap delay generation circuit is implemented; however, the principles of the present invention may be applied to any, and larger multi-tap delay systems. A preconditioning circuit 12, for example, low-pass filter, limiting amplifier or other suitable filtering or signal-shaping device, accepts the input signal 11 and creates a preconditioned signal 13 with rise/fall times that are suitable for use in the invention. If rise/fall times are too fast, non-linearities will exist after the taps are summed which will be demonstrated later. If rise/fall times are two slow, then unnecessary jitter may result from noises introduced in the processing. Ideal rise/fall times are in the range similar to twice the required delay range divided by the number of taps, N. In this way, sums performed to compute the output delayed signal 30 always have non-level (all zero or all one) components from at least two taps in the areas of the output transitions.

The preconditioned signal 13 is split or otherwise divided into N-tap paths. For purposes of explanation and illustration, as used herein, a tap path forms a portion of the variable delay generation circuit of the present invention and includes a delay circuit or element 14 and a corresponding scaling circuit 18. The delay element 14 may be provided, for example, by a delay circuit, such as a buffer or other suitable device, or an elongated signal trace formed on a circuit board that contains the delay generation circuit components or a larger device that incorporates the variable delay generation circuit 10. The scaling circuit 18 may be, for example, an amplifier such as an operational, limiting amplifier, variable attenuation circuit or other suitable deice. Delay is introduced in each of the paths relative to the first path. In an exemplary embodiment of the present invention a 2-tap device with a desired delay range of 21 picoseconds, a 25 picosecond delay is inserted between the two taps. In this embodiment, this fixed delay 14 is introduced, for example, by using a slightly longer (approximately 0.3") copper trace on a printed wiring board. Other ways that fixed delay could be introduced into the tap paths are also anticipated by this invention and would also work well.

Each tap path must then be scaled, for example, by gain or attenuation or amplifier circuits 16, 18, 29 by an appropriate amount before all their results are summed by summing circuit 20. Scaling factors that do not add to 1 will result in variable delayed output trigger signals that are also scaled. This circumstance is typical and does not deter from the fact that the output signal 30 does have variable delay introduced. Scaling factors 16, 18, 29 for each tap that are less than one can easily be introduced using variable attenuators. These devices offer very high-speed performance with commercially available off-the-shelf components and are what is used in the exemplary 2-tap embodiment of the present invention. Individual taps may also be inverted versions (scaled by -1) of other taps as long as this is accounted for in the final summing operation. For example, a preconditioned input signal could be split into two taps paths by using a differential amplifier device that outputs a TRUE and INVERTED copy of the signal as two separate outputs. After these signals are appropriately delayed with respect to each other and then scaled, they can be combined using a SUBTRACTION with the result being the same as if two TRUE-level signals were processed and then SUMMED. This and like algebraic manipulations of the processing paths are not novel and are well understood by those trained in the art of high-speed signal processing.

The summing operation may also include a limiting-amplifier feature to provide high-gain to the result of the sum and then limit its output to the appropriate high and low voltage levels for the desired waveform output. This operation, while not necessary, will serve to further reduce the effects of possible noises introduced in the processing.

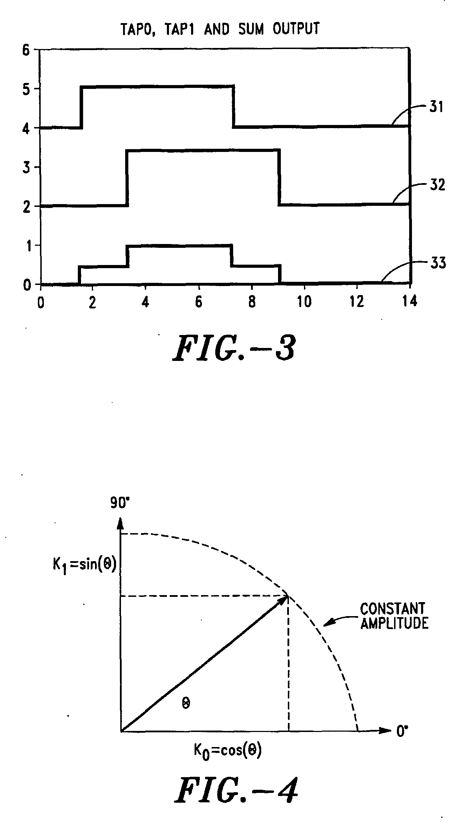

Fig. 2 demonstrates a representative example of possible gain coefficients K0, K1 that may be applied in the exemplary 2-tap embodiment of present invention. In this example, a linear set of coefficients that implement a direct cross-over from one tap's waveform on the output to the other tap's waveform on the output is shown. This example is for demonstration only. As we will see and although this is a legitimate choice of gain coefficients, this is a poor choice as the resulting sum when working with real-life signals will result in output edge shapes after the summing operation that are not smooth. In this graph, the Y-axis indicates how much gain/attenuation (I) to apply to that tap's signal as it travels on its way to the summing circuit and the X-axis is the amount of delay (Δt) that is desired to be introduced in the output. For example, if minimum delay (Tmin) is to be introduced, K0 would be set to 1 (or maximum) and K1 would be set to 0. The resulting summed output would simply be a copy of the first-tap's input and this would clearly have the Tmin delay value. Likewise, if the maximum (Tmax) delay was desired, then K0 would be set to 0 and K1 would be set to 1 (or maximum). The resulting summed output would then be a copy of the input signal with the added delay introduced into the second tap path; this would be Tmax. To achieve a variable delay that is, say, halfway between Tmin and Tmax, then K0 and K1 would both be set to 0.5 and the output would become one half of the input signal plus one half of the input signal when delayed by the fixed delay introduced into the second tap path. This linear combination would have its output edge delayed as well depending on the shape of the rise/fall time that was used.

Fig. 3 is a timing diagram of the case where rise/fall times of 0 (straight edges) were used with the variable delay generation circuit of the present invention. As we will see, this will not work for this invention and it is therefore required that we have finite edge rise/fall rates. The top trace in Fig. 3 shows an input trigger signal 31 with a rising and falling edge. The second trace in Fig. 3 shows the same input trigger signal delayed 32 by a fixed amount of delay. In this example, the top trace represents the signal in the first tap of the invention structure and the second trace represents the second tap. The third trace 33 demonstrates what the summing output would look like if these zero rise/fall time input signals were used. Here we see that the output waveform 33 starts to transition when the signal in the first tap starts to transition and that it ends the transition when the signal in the second tap ends its transition; however, in between these two extents, the signal sits at a middle voltage dependent on the programmed delay requested and the type of coefficient calculations used. In this example, with zero rise/fall times, there is no way to avoid sitting at another mid-voltage when doing this sum. In order to avoid this, each signal input to the summing network must have a finite and reasonable rise/fall time.

Fig. 4 illustrates an alternative to linear coefficients and zero rise/fall time signals described earlier. It is clear that non-zero rise/fall times are needed. One possible approach is to have rise/fall times that are sinusoidal (as is nearly the case in very high speed processing where physical layer interconnects are pushed to their highest speeds and are bandwidth limited). If we consider our input signal to be a sine wave, then we have rise and/or fall activity for π/2 rad. By using the delay between taps for this present invention of π/2 rad, then each tap will add to the sum at a 90 degree phase shift. If we want the output voltage to be constant when summing two sine waves that are 90 degrees out of phase, then the coefficients of the summing paths can be easily calculated. In Fig. 4 we show the computations of gain coefficients K0 and K1 in this case. Here we see that K0 must equal the cosine of the desired delay phase and K1 must equal the sine of the desired delay phase. The delay phase in both these cases is the amount of delay compared to the full-speed sine wave signal applied. The fixed delay introduced into the different taps is what is required to achieve the 90 degree phase shift. In the two-tap embodiment of this invention, the fixed delay implemented, 25 picoseconds, represented π/2 rad for a 10GHz sine wave. Note that this does not limit the useable range of this embodiment of the present invention to 10GHz trigger input signals as real input signals do not have purely sine wave transition responses; however, this sine wave example demonstrates how computations of gain coefficients K0, K1 ... Kn exist that will cause the resulting delayed output to have smooth output transitions.

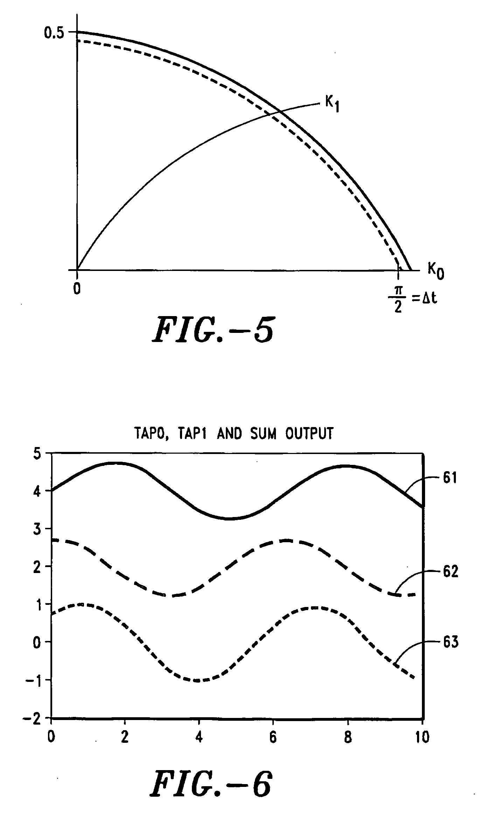

In Fig. 5, we see the computed gain coefficient values K0 and K1 for the exemplary two-tap embodiment of this invention where K0 is COS(θ) and K1 is SIN(θ) and θ is the desired phase angle of delay at this maximum sine wave frequency case. Achieving Tmin delay is easily accomplished by setting theta = 0 and summing COS(0) times the signal in the first tap plus SIN(0) times the signal in the second tap. This results in simply creating a copy of the signal in the first tap. Again, Tmax can be created by setting theta to be π/2 and summing COS(π/2) times the signal in the first tap plus SIN(π/2) times the signal in the second tap. A more interesting example is illustrated when we compute the sum when a delay in between Tmin and Tmax is desired. In this case, we always get a smoothly varying sum result, which results in a useable output delayed signal shape.

Fig. 6 is a timing diagram that demonstrates the sine wave case for the exemplary two-tap embodiment of the present invention. The top trace 61 shows an example input waveform that would also represent the timing of the signal in the first tap path. The second trace 62 shows a copy of input signal 61 delayed by π/2 rad and, represents the timing of signal that would be going down the second tap path. The two paths are then increased by the appropriately calculated gain coefficients and summed. In this example, we show the case for a required π/4 degrees of phase shift. In this case, the resulting output waveform 63 is a smoothly varying waveform that can easily be seen to have a delay introduced that is in between Tmin and Tmax. The amplitude of this summed waveform, again, does not need to be unity gain from the input signal as our goal is to achieve variable delay and we are relatively insensitive in this application to amplitude variations that may be introduced.

Fig. 7 demonstrates how a mixture of the two extremes already introduced (zero rise/fall times and sinusoidal) are used in the exemplary two-tap embodiment of present invention. In this case, the top trace 71 shows an input trigger signal with both a rising and falling edge where the edge rate has been slowed down to a nominal time that is around the amount of delay range desired. Further, the second trace 72 shows the fixed delay introduced into the second tap path with like rise and fall times. With these signals defining the timing of the signals in the first and second taps, we can see that a sum of the two signals now result in a smoothly varying output delay signal 73 when K0 and K1 coefficients that are based on the same sine/cosine computations are used. For example, to achieve Tmin delay, K0 = COS(0), K1= SIN(0) and the output signal 73 becomes a copy of the signal in the first tap path. To achieve Tmax delay, K0= COS(PI/2), K1= SIN(PI/2) and the output signal 73 becomes a copy of the signal in the second tap path. To achieve a delay that is in between Tmin and Tmax (as is shown in the third trace in Fig. 7), the desired delay is translated to a desired θ phase angle of delay and the output delayed signal 73 becomes a sum of the linear combination. As is shown in the third trace 73, a smoothly varying output edge results.

Because the transition edge shape of the input signal is not purely sinusoidal, gain coefficients that are not purely sinusoidal-based can result in even smoother output transition shape. Empirical results of combinations of K0 and K1 achieve this result.

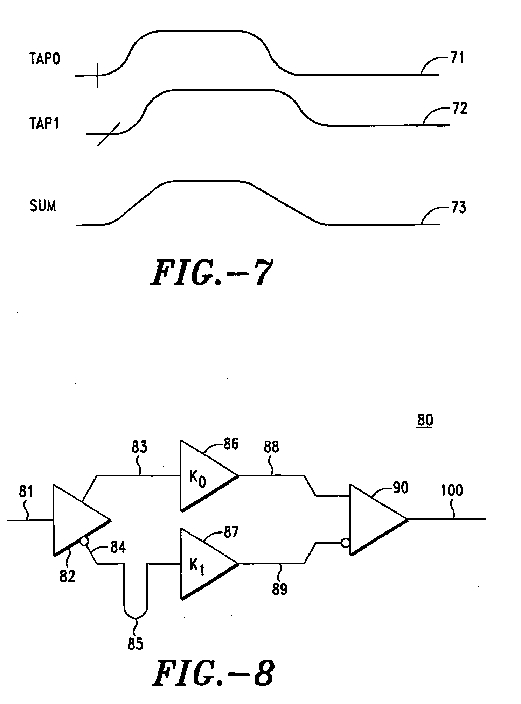

Fig 8 is a schematic block diagram of a two-tap embodiment of the present invention where limiting amplifiers are used as preconditioning circuits 82 and post limiting amplification circuits 90. The fixed added delay 85 between the two tap paths is introduced by elongating the trace on a printed wiring board and the gain coefficients are implemented with variable attenuators 86, 87. In this embodiment, the input signal 81 is reshaped by the fixed output rise/fall times present in the first limiting amplifier 82. Both the positive 83 and negative leg 84 of the first limiting or preconditioning amplifier 82 are used as the two input signals for the two paths. One path is presented directly to a first variable attenuator circuit 86 which may be implemented, for example, by an operational amplifier, a radio frequency (RF) device or other suitable device, and the second path is presented to a second variable attenuator circuit 87 which may be implemented, for example, by an operational amplifier, a radio frequency (RF) device or other suitable device, through a slightly longer trace 85 used to implement the delay offset of the second tap path. The outputs of the two variable attenuators 88, 89 are presented with equal delay to the differential inputs of the second limiting amplifier 90. Because the input stage of this variable delay circuit 80 is a differential amplifier 82, the resulting operation will be a subtraction of the two input signals 88, 89. Because one input signal is the inverted case of the other, the resulting overall math operation is the summing operation desired. This second limiting amplifier 90 provides high-gain to the result of the sum and helps to reduce unwanted jitter.

The improvements over the state of the art by this invention can now be further analyzed. Characteristics such as delay resolution, delay range and stability, delay setting time, delay temperature dependency, maximum operating frequency and manufacturing variation are all important improvements in this invention. Delay resolution in the generation circuit of the present invention is dependent largely on the resolution of the variable gain/attenuator functions. Commonly available technology exists to have variable attenuation be a function of a controlling analog voltage (a so called, voltage variable attenuator). In these cases, an analog control voltage is used to control the amount of desired attenuation. The resolution of the delay setting ability then translates to the resolution of being able to set these control voltages. In the exemplary two-tap embodiment of the present invention, a 10-bit DAC is used to create this control voltage which roughly translates to one part in a 1000 to cover the Tmin-Tmax delay range (20 picoseconds in this example case). This indicates that delay resolutions on the order of 20 femptoseconds are easily attained. If more resolution was required, higher resolution DACs could also be employed.

The range of this delay is completely scaleable while not trading-off delay resolutions as new tap sections are added to add more range. The range that is built out of even a 2-tap embodiment easily achieves 20 picoseconds which is sufficiently small to allow very fine delay resolutions while also being sufficiently large as to not require too many additional delay components in a switched-in fixed-delay structure to implement a continuously variable delay feature that covers many bit periods for popular high-speed communications systems. For example, the exemplary two-tap embodiment of the present invention has been concatenated with a eight overlapping sections of additional switched-in delays to implement variable delay in excess of 1000 picoseconds while still maintaining nearly 20 femptoseconds of delay resolution.

The stability of the amount of delay that can be inserted with this technique is dependent on the repeatability of the preconditioning circuits and the variation in the delay introduced in between taps. In the exemplary two-tap embodiment of the present invention, the preconditioning device was a high-performance limiting amplifier who's output rise/fall times are designed to a specification. The tolerance of this invention to changes in the rise/fall times is great as we have shown that variable output delays can be achieved when edge rise/fall rates variation that is more than 2:1. In the exemplary two-tap embodiment of the present invention, rise/fall edge rates of around 25 picoseconds are used to achieve an output delay range of 20 picoseconds. The rise/fall times can easily change from 15 to 30 picoseconds while still allowing for smooth output transition on the post-summed output. The actual delay range does not change significantly as the edge rise/fall times change.

The time it takes to make a new delay setting in this invention corresponds to the time it takes to change the coefficients for all the taps. For example, in a two-tap embodiment of the present invention, this translates to the amount of time it takes to write two 10-bit DACs and to have them settle. It is easily within reach of readily available computer, DAC and Operational Amplifier technology to make a delay setting change in a small number of microseconds. This easily outperforms older mechanical stepper-motor based delay technologies.

The temperature dependence of this new variable delay technology depends on the temperature dependence of the individual sub-components such as the pre-conditioner, fixed trace delay, variable gain/attenuation stages and summing circuit. Of all of the components of temperature dependency, the strongest is the dependency of the variable gain/attenuation function. Because in this invention variable delay becomes a function directly related to variable gain/attenuation, this invention directly benefits from commonplace techniques for stabilizing the variable gain/attenuation function. In the exemplary two-tap embodiment of the present invention, commercially available voltage variable attenuators are used to achieve the attenuation function. In these devices, FET amplifiers are used to create variable resistors where the value of the resistance is a function of a control voltage. As the resistor values may change as a function of temperature, a second set of FET transistors are built-in to the same substrate to act as a real-time calibration information source for the device. By using a well-understood feedback loop to set the amount of FET control voltage to achieve the desired resistance in the calibration path, required changes for the FET control voltage in the main signal path can also be made. In this well understood way, the amount of attenuation for devices can be made to be very stable with respect to temperature variation. Consequently, this invention can create variable delay output that is also very stable with respect to temperature variation.

The maximum operating frequency at which this delay technology can operate depends on the maximum operating frequency of the individual sub-components such as the pre-conditioner, the variable gain/attenuation devices and the summing circuit. Preconditioners and summers can be made from commercially available limiting amplifiers. These devices tend to be readily available at some of the highest speeds attainable by today's semiconductor processing technologies as these components tend to be important building-blocks for other elements. Variable gain functions can be very limiting in high-frequency performance when amplifiers are needed; however, for variable attenuation functions, only programmable resistors are needed. As proven by the large availability of very high speed voltage variable attenuators, this is a well understood problem in RF microcircuits.

Other manufacturing variations can also exist in commonly available variable delay technology which can dramatically affect the speed of operation, delay range, delay resolution or stability. In this invention, like many, the speed of the semiconductor components is the most significant variation to the variable delay characteristic. However, unlike other implementations, this variable delay technology sets its delay range based predominantly on the fixed delay element which is easily implemented with technologies that offer very low manufacturing variation coefficients (i.e. fixed trace delays photographically etched into a printed wiring board). Semiconductor speed variations may affect the edge rates of the preconditioner and/or the speed of the summing circuit, but these changes have relatively small impact in the output variable delay. Semiconductor variations that affect the variable gain/attenuation function will, in fact, have impact on the variable delay characteristic; however, as we have already shown, commercial technology already exists to allow for easy compensation for these types of variations.

## Claims

1. A variable delay generation circuit, comprising:
a preconditioning circuit operative to provide a preconditioned signal in response to an input signal;
at least two delay tap paths, coupled to the preconditioned signal, operative to provide delayed versions of the preconditioned signal (19), the delay tap paths including a delay element and a scaling circuit; and
a summing circuit, coupled to at least two delay tap paths, operative to provide an output signal exhibiting variable delay characteristics in response to the preconditioned signal and the scaling circuit.

2. The variable delay generation circuit as defined in Claim 1, wherein the delay element further includes an elongated signal trace formed on a printed circuit board that contains the delay generation circuit.

3. The variable delay generation circuit as defined in Claim 1, wherein the delay element further includes a fixed delay.

4. The variable delay generation circuit as defined in Claim 1, wherein the preconditioning circuit further comprises a limiting amplifier.

5. The variable delay generation circuit as defined in Claim 1, wherein the preconditioning circuit further comprises one of the group consisting of: a band-pass filter, a high-pass filter, a low-pass filter.

6. The variable delay generation circuit as defined in Claim 1, further including a post limiting amplification device operative to reduce jitter in the output signal and who's differential input is used as the summing element.

7. A variable delay generation circuit, comprising:
a differential preconditioning circuit operative to provide a preconditioned signal in response to an input signal;
a first variable attenuation circuit, coupled to the differential preconditioning circuit, operative to provide a variable attenuated preconditioned signal;
a delay element, coupled to a negative leg of the differential preconditioning circuit, operative to provide a fixed delayed preconditioned signal;
a second variable attenuation circuit, coupled to the fixed delayed preconditioned signal, operative to provide an attenuated delayed negative differential signal; and
a post limiting amplification circuit, coupled to the first variable attenuation circuit and the second variable attenuation circuit, operative to provide a variable output signal in response to the variable attenuated preconditioned signal and the attenuated delayed negative differential signal.

8. The variable delay generation circuit of Claim 7, wherein the differential preconditioning circuit further comprises a limiting amplifier.

9. The variable delay generation circuit of Claim 7, wherein the delay element further comprises an elongated trace route between the negative output of the differential preconditioning circuit.

10. The variable delay generation circuit of Claim 7, wherein the delay element further comprises a fixed-length delay device.

11. The variable delay generation circuit of Claim 10, wherein the fixed-length delay device adds a π/2 delay to the negative output of the differential reconditioning circuit.
